# EUROPEAN PATENT SPECIFICATION

(11) **EP 0 919 593 B1**
(45) Date of publication and mention of the grant of the patent: **07.04.2004**
(21) Application number: 98122194.8
(22) Date of filing: 27.11.1998
(51) Int. Cl.: C08L 79/08, C08J 5/18, C08K 3/22, C08K 5/00

(54) **Aromatic polyimide film having improved adhesion**
Aromatische Polyimidfolie mit verbesserter Haftung
Film de polyimide aromatique ayant une adhérence améliorée

(30) Priority: 28.11.1997 JP 32846097; 26.12.1997 JP 35979297; 28.07.1998 JP 21234598
(43) Date of publication of application: 02.06.1999
(73) Proprietor: Ube Industries, Ltd., Ube-shi, Yamaguchi-ken 755-0052 (JP)
(72) Inventor: Yamaguchi, Hiroaki, c/o Polymer Res. Lab., Ichihara-shi, Chiba (JP); Watakabe, Hideharu, c/o Ube Chemical Factory, Ube-shi, Yamaguchi (JP); Anno, Toshihiko, c/o Ube Laboratories, Ube-shi, Yamaguchi (JP); Ozawa, Hideki, c/o Polymer Res. Lab., Ichihara-shi, Chiba (JP)
(74) Representative: Albrecht, Thomas, Dr.

(56) References cited:
- EP-A- 0 441 321
- US-A- 3 926 916
- US-A- 4 284 461
- US-A- 5 260 413
- US-A- 5 272 194
- US-A- 5 541 238

## Description

The present invention relates to an aromatic polyimide film having improved adhesion and further relates to an aromatic polyimide/metal (or metal oxide) composite sheet.

An aromatic polyimide film shows a high heat resistance as well as good electric characteristics, and are widely employed as material for producing electronic devices. The aromatic polyimide film, however, has such a disadvantageous feature as poor adhesive property to an adhesive ordinarily employed for constituting electronic devices. Further, a metal film deposited on the aromatic polyimide film by sputtering shows poor adhesion to the polyimide film and is easily peeled off from the polyimide film. Therefore, studies for improving the poor adhesive property of an aromatic polyimide film have been made and reported.

United States Patent 5,218,034 describes a polyimide film having improved adhesion and thermal durability containing from 0.02 to 1% by weight of tin based on the weight of the film.

United States Patent 5,543,222 describes a vacuum metallized polyimide film comprising an aromatic polyimide layer containing a hydrocarbyl tin compound in oxidation states (II) or (IV) as an additive and metal plated layer bonded integrally with a high bonding strength or high adhesion through a vacuum deposited metal layer without the use of an adhesive.

United States Patent 5,272,194 describes a strengthened polyimide film having improved adhesion when bonded to a metal foil through a heat-resistant adhesive, containing from 0.02 to 1% by weight, based on the weight of the film, of an organo-metallic compound wherein the metal is tin, bismuth or antimony.

United States Patent 5,227,244 describes a polyimide film having improved adhesion prepared by coating the surface of a partially cured or partially dried polyamide acid film with an organic solvent solution of a metal salt and heating the coated film to both convert the polyamide acid to polyimide and dry the film. The metal salt is a salt of Sn, Zn, Cu, Fe, Co, Mn, or Pd.

Japanese Patent Provisional Publications 59-86634 and H2-134241 describe that a polyimide film can be improved in its adhesion by plasma discharge processing.

Japanese Patent Provisional Publication H1-214840 describes a process for preparing a polyimide pattern which comprises the steps of forming a film of an aluminum alcoholate or an aluminum chelate compound on a film of polyimide or its precursor, coating a photoresist on the aluminum-compound layer, imagewise exposing the photoresist coat to light, and etching the light-exposed photoresist.

### SUMMARY OF THE INVENTION

It is a main object of the present invention to provide a new aromatic polyimide film showing improved adhesion and low electro-conductivity.

It is another object of the invention to provide a composite sheet comprising an aromatic polyimide layer and a metal or metal oxide layer, in which the composite sheet has a high bonding strength between the polyimide layer and the metal or metal oxide layer and the polyimide layer shows low electro-conductivity.

The present invention resides in an aromatic polyimide film comprising an aromatic polyimide resin and an aluminum-containing material dispersed in the polyimide resin in an amount of 1 to 1,000 ppm (in terms of the amount of aluminum element) per the amount of the polyimide film.

The invention further resides in an aromatic polyimide composite sheet comprising an aromatic polyimide film and a metal or metal oxide layer arranged on one or both surfaces of the film in which the polyimide film comprises an aromatic polyimide resin and an aluminum-containing material dispersed in the polyimide resin in an amount of 1 to 1,000 ppm (in terms of the amount of aluminum element) based on the amount of the polyimide film, and the metal or metal oxide layer is formed on the film via no adhesive.

### BRIEF DESCRIPTION OF THE DRAWINGS

Fig. 1 is a schematic section of a representative composite sheet of the invention.
Fig. 2 is a schematic section of another representative composite sheet of the invention.
Fig. 3 is a schematic section of a further representative composite sheet of the invention.

### DETAILED DESCRIPTION OF THE INVENTION

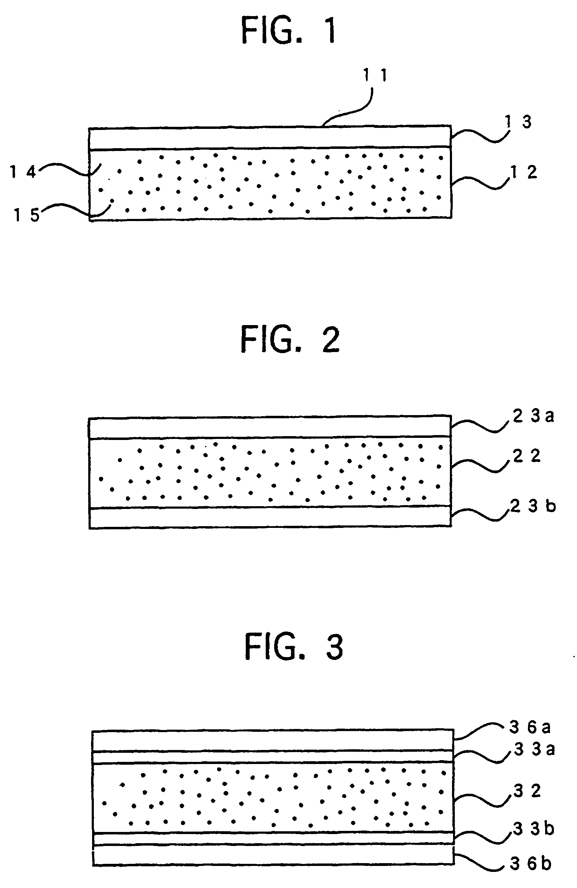

A representative composite sheet of the invention is illustrated in Fig. 1, in which the composite sheet 11 is composed of an aromatic polyimide film 12 and a metal or metal oxide layer 13 provided on the polyimide film 12. The polyimide film 12 comprises an aromatic polyimide phase 14 and an aluminum-containing material 15 which is dispersed in the polyimide phase 14. The metal or metal oxide layer 13 is formed on the polyimide film 12 generally by sputtering, vacuum deposition, or electron beam deposition and is firmly bonded to the polyimide film 12.

In the composite sheet of the invention, the metal or metal oxide layer can be placed on both sides of the polyimide film. Fig. 2 shows a typical structure of the composite sheet in which a metal or metal oxide layer 23a, 23b is placed on both sides of the polyimide film 22.

The composite sheet of the invention can comprise a metal film, a metal or metal oxide layer, an aromatic polyimide film, a metal or metal oxide layer, and a metal film, placed in order. Figure 3 indicates a typical structure of the composite sheet of this type, in which a metal or metal oxide layer 33a, 33b, and a metal film 36a, 36b are placed on both sides of an aromatic polyimide film 32.

The polyimide film of the invention comprises an aromatic polyimide resin and an aluminum-containing material dispersed in the polyimide resin in an amount of 1 to 1,000 ppm, preferably 4 to 1,000 ppm, based on the amount of the polyimide film.

The polyimide film of the invention comprises a resin matrix of an aromatic polyimide resin. The aromatic polyimide resin is preferably composed of an aromatic tetracarboxylic acid residue and an aromatic diamine residue. The aromatic tetracarboxylic acid residue is preferably derived from an aromatic tetracarboxylic dianhydride, and the aromatic diamine residue is preferably derived from an aromatic diamine. A small portion of the aromatic tetracarboxylic acid residue can be an aliphatic tetracarboxylic acid residue, and a small portion of the aromatic diamine residue can be an aliphatic diamine. The polyimide resin can contain an aminodicarboxylic acid residue such as 4-aminophthalic acid residue, 4-amino-5-methylphthalic acid residue, or 4-(3,3'-dimethyl-4-anilino)phathalic acid residue, in addition to the aromatic tetracarboxylic acid residue and the aromatic diamine residue.

Examples of the aromatic tetracarboxylic acid dianhydrides include 3,4,3',4'-biphenyltetracarboxylic dianhydride (hereinafter, referred to as s-BPDA), pyromellitic dianhydride, benzophenonetetracarboxylic dianhydride, and bis(3,4-dicarboxyphenyl)ether dianhydride (i.e., oxydiphthalic dianhydride).

Examples of the an aromatic diamines include p-phenylene diamine and 4,4'-diaminodiphenyl ether. A portion of the aromatic diamine can be replaced with an aromatic diamine having plural benzene rings and a flexible structure such as 4,4'-diaminodiphenylsulfide, 4,4'-diamino-benzophenone, 4,4'-diaminodiphenylmethane, 2,2-bis(4-aminophenyl) propane, 1, 4-bis (4-aminophenoxy)benzene, 4,4'-bis(4-aminophenyl)diphenyl ether, 4,4'-bis(4-aminophenyl)diphenylsulfone, 4,4'-bis(4-aminophenyl)diphenylsulfide, 4,4'-bis(4-aminophenyl)diphenylmethane, 4,4'-bis (4-aminophenoxy) diphenyl ether, 4,4'-bis (4-aminophenoxy)diphenylsulfone, 4,4'-bis(4-aminophenoxy)diphenylsulfide, 4,4'-bis(4-aminophenoxy)diphenylmethane, 2,2-bis[4-(aminophenoxy)phenyl]propane, or 2,2-bis[4-(4-aminophenoxy)phenyl]hexafluoropropane, an aliphatic diamine such as 1,4-diaminobutane, 1,6-diaminohexane, 1,8-diaminooctane, 1,10-diaminodecane, or 1,12-diamino-dodecane, and other aromatic diamines such as xylylenediamine.

The aromatic polyimide resin preferably has a low linear expansion coefficient such as that in the range of 0.5 x 10⁻⁵ to 2.5 x 10⁻⁵cm/cm/°C, more preferably, 1 x 10⁻⁵ to 2 x 10⁻⁵cm/cm/°C, in the temperature range of 50 to 250°C. The aromatic polyimide resin having such low linear expansion coefficient can be prepared from a combination of 3,3',4,4'-biphenyltetracarboxylic dianhydride and p-phenylene diamine, a combination of a mixed aromatic tetracarboxylic acid components such as a mixture of pyromellitic dianhydride, 3,3',4,4'-biphenyltetracarboxylic dianhydride and benzophenonetetracarboxylic dianhydride, and p-phenylene diamine (hereinafter referred to as PPD) alone or a mixed diamine components such as a mixture of PPD and 4,4'-diaminodiphenyl ether (hereinafter referred to as DADE). PPD and DADE are preferably employed in a molar ratio of 100/0 to 15/85 (PPD/DADE). The polyimide can be in any form of a homopolymer, a random copolymer and a block copolymer. The polyimide can also be prepared by separately producing two or more kinds of polyamide acids, mixing these polyamide acids, and heating the mixed polyamide acids to give a polyimide film.

The polyimide film can be prepared by reacting in an organic solvent the aromatic tetracarboxylic acid component and the aromatic diamine component in approximately equimolar ratio at a temperature of lower than approximately 100°C, preferably 20 to 60°C, to give a polyamide acid solution (in which a portion of the polyamide acid may be already converted into a polyimide), and the polyamide acid solution (dope solution) is casted on an appropriate support and heated to a temperature of 70 to 200°C to give a dry film. The dry film is then separated from the support and heated to a temperature of higher than 420°C, preferably a temperature of 430 to 520°C, preferably for 2 to 30 min., to convert the polyamide acid to a polyimide. Thus prepared polyimide film preferably has a thickness of 25 to 125 µm, more preferably 45 to 125 µm.

The organic acid employed for the preparation of the polyamide acid can be N-methyl-2-pyrrolidone, N,N-dimethylformamide, N,N-dimethylacetamide, N, N-diethylacetamide, dimethylsulfoxide, hexamethylphosphoramide, or N-methyl-caprolactam. These organic solvents can be employed singly or in combination. In the reaction solution, an organic base compound such as imidazole, 2-methylimidazole, 1,2-dimethylimidazole, 2-phenylimidazole, or triethylamine can be incorporated so as to accelerate the desired imidation. The organic base compound can be incorporated into the reaction solution in an amount of 0.1 to 10 weight %, based on the solid content of the solution. In the reaction solution, an organic phosphorus compound such as triphenyl phosphite, triphenyl phosphate, or alkyl phosphate can be also incorporated in an amount of 0.05 to 1 weight % (based on the amount of solid content) so as to facilitate the separation of the dry polyamide acid film from the support.

The polyimide resin can be a heat-resistant polyamideimide resin.

The polyimide film of the invention contains therein an aluminum-containing material such as aluminum oxide. The aluminum-containing material can be incorporated into the polyimide film by mixing an aluminum compound with the polyamide acid solution or coating a solution of an aluminum compound on a wet or dry film of the polyamide acid solution and then heating the polyamide acid and the aluminum compound together to prepare a polyimide film containing therein an aluminum-containing material which is given by thermal conversion of the aluminum compound.

The aluminum compound is preferably soluble in the polyamide acid solution. Examples of the aluminum compounds include aluminum hydroxide or organic aluminum compounds such as aluminum monoethylacetate diisopropylate, aluminum diethylacetate monoisopropylate, aluminum triacetylacetonate, aluminum triethyl acetonate, aluminum isopropylate, and aluminum butyrate. The most preferred organic aluminum compound is aluminum triacetylacetonate. When the solution of aluminum compound is coated on the polyamide acid film, the solution is preferably prepared by dissolving the aluminum compound in a solvent such as an alcohol, an aromatic hydrocarbon, an aliphatic hydrocarbon, an alicyclic hydrocarbon, a ketone solvent, an ether solvent, or an amide solvent. In the solution, the aluminum compound is preferably contained in an amount of 0.01 to 5 weight %, more preferably 0.02 to 5 weight %.

The aluminum compound is heated to an elevated temperature such as a temperature of higher than 420°C in the polyamide acid film in the imidation reaction. Therefore, most of the aluminum compound is turned into aluminum-containing material such as aluminum oxide. In the resulting polyimide film, the aluminum-containing material is contained in an amount (in terms of the amount of its aluminum element) of 1 to 1,000 ppm, preferably 4 to 1, 000 ppm. If the content of aluminum element is less than 1 ppm, satisfactory improvement of adhesion cannot be expected, while if the content of aluminum element is higher than 1,000 ppm, the physical strength of the polyimide film lowers and the adhesion is not satisfactory.

On the polyimide film containing therein the aluminum-containing material, a metal layer or metal oxide layer is placed. The metal layer or metal oxide layer can be formed on the polyimide film using no adhesive, for instance, by vacuum deposition, ion-beam deposition, sputtering, or plating. When the deposition method is employed, the deposition is preferably performed under the conditions of 10⁻⁷ to 10⁻² Torr, a deposition rate of 50 to 5,000 A/sec, and a temperature (i.e., film temperature) of 20 to 600°C. The sputtering is preferably performed by RF magnet sputtering under the conditions of less than 1 Torr, preferably 10⁻³ to 10⁻² Torr, a temperature of 200 to 450°C, and a deposition rate for the layer formation of 0.5 to 500 A/sec.

The metal layer or metal oxide layer preferably comprises copper, copper alloy, aluminum, tin, tin alloy, or palladium, or its oxide. The metal layer or metal oxide layer can comprise a subbing layer of chromium, titanium, or palladium and a surface layer of copper.

The metal layer or metal oxide layer generally has a thickness of not more than 2 µm, preferably not more than 1 µm, more preferably 0.01 to 1.0 µm.

On the metal layer or metal oxide layer on the polyimide layer can be placed a metal film by plating. The metal film to be plated preferably comprises copper, copper alloy, or silver. The metal plating can be performed by electrolytic process or non-electrolytic process. The plated metal film preferably has a thickness of 1 to 40 µm.

The polyimide film having the metal layer or metal oxide layer on its surface shows a high heat-resistance and a high mechanical strength, and it receives a metal film on its metal or metal oxide layer and keep it with high bonding strength. Therefore, the polyimide film having the metal layer or metal oxide layer on its surface according to the invention can be favorably employed as material for the preparation of electronic devices such as MCM (Multi Chip Module) and FPC (Flexible Printed Circuit Board).

The present invention is further described by the following Examples.

### Examples 1 to 2

### (1) Dope solution for preparing polyimide film

In 300 mL-volume glass reaction vessel equipped with a stirrer, a nitrogen gas-inlet tube and a reflux condenser, 183 g of N,N-dimethylacetamide and 0.1 g of a phosphoric acid compound (Separ 365-100, available from Chukyo Oil and Fat Co., Ltd.) were placed. The N,N-dimethylacetamide and the phosphoric acid compound were stirred in a nitrogen stream, and to the mixture was added 10.81 g (0.1000 mol.) of p-phenylenediamine. The resulting mixture was then warmed at 50°C to give a homogeneous solution. To the solution was potionwise added 29.229 g (0.09935 mol.) of 3,3',4,4'-biphenyltetracarboxylic dianhydride, taking a care to obviate extreme heat generation. After the addition was complete, the reaction mixture was stirred at 50°C for 5 hours. Subsequently, 0.2381 g (0.00065 mol.) of 3,3',4,4'-biphenyltetracarboxylic acid dihydrate was dissolved in the resulting solution. Thus, a viscous brown colored polyamide acid solution showing a viscosity of approximately 1,500 poise (at 25°C) was prepared.

### (2) Preparation of polyimide film

The polyamide acid solution obtained in (1) above was spread on a glass plate and heated to 150°C for 10 min. to dryness. The dried polyamide acid film was separated from the glass plate and fixed on a frame. On the fixed polyamide acid film was coated an aluminum triacetyl acetonate solution (in toluene) having a concentration set forth in Table 1. The film was then heated at 200°C for 3 min. , 300°C for 3 min. , and 480°C for 4 min., sequentially, to give a polyimide film having a thickness of 50 µm and showing a linear expansion coefficient of 1.5 x 10⁻⁵ cm/cm/°C at a temperature range of 50 to 250°C. The linear expansion coefficient was measured at a temperature elevation rate of 10°C/min.

### (3) Preparation of composite sheet

The polyimide film was cleaned on its surface having been coated with the aluminum compound, and on thus cleaned surface was formed a copper layer of 0.2 µm thick by electron beam deposition under the following conditions:
Film temperature: 150°C
Pressure: lower than 2 x 10⁻⁴ Pa
Copper purity: 4N
Deposition rate: 10 - 25 A/sec.

On the deposited copper layer was plated a copper film of 10 µm thick by electrolytic plating, to give a composite sheet.

### Example 3

In the polyamide acid solution prepared in the same manner as in Examples 1 to 2, aluminum hydroxide in an amount set forth in Table 1 was dissolved, to give a homogeneous dope solution. The dope solution was spread on a glass plate and heated to 150°C for 10 min. to dryness. The dried polyamide acid film was separated from the glass plate and fixed on a frame. The film was then heated at 200°C for 3 min., 300°C for 3 min., and 480°C for 4 min., sequentially, to give a polyimide film having a thickness of 50 µm.

The polyimide film was then treated in the same manner as in Examples 1 to 2 to give a composite sheet.

### Examples 4 to 5

A dry polyamide acid film was prepared on a glass plate in the same manner as in Examples 1 to 2. The dry polyamide acid film was separated from the glass plate and fixed on a frame. On the fixed polyamide acid film was coated a solution of an aluminum chelate compound (ALCH, available from Kawaken Fine Chemical Co., Ltd., in dimethylacetamide) having a concentration set forth in Table 1. The film was then heated at 200°C for 3 min., 300°C for 3 min., and 480°C for 4 min., sequentially, to give a polyimide film having a thickness of 50 µm.

The polyimide film was then treated in the same manner as in Examples 1 to 2 to give a composite sheet.

### Example 6

In the polyamide acid solution prepared in the same manner as in Examples 1 to 2, aluminum hydroxide in an amount set forth in Table 1 was dissolved, to give a homogeneous dope solution. The dope solution was spread on a glass plate and heated to 150°C for 10 min. to dryness. The dried polyamide acid film was separated from the glass plate and fixed on a frame. On the fixed polyamide acid film was coated an aluminum triacetyl acetonate solution (in toluene) having a concentration set forth in Table 1. The film was then heated at 200°C for 3 min., 300°C for 3 min., and 480°C for 4 min., sequentially, to give a polyimide film having a thickness of 50 µm.

The polyimide film was then treated in the same manner as in Examples 1 to 2 to give a composite sheet.

### Example 7

A dry polyamide acid film was prepared on a glass plate in the same manner as in Examples 1 to 2. The dry polyamide acid film was separated from the glass plate and fixed on a frame. On the fixed polyamide acid film was coated a solution of an aluminum chelate compound (ALCH, available from Kawaken Fine Chemical Co., Ltd., in dimethylacetamide) having a concentration set forth in Table 1. The film was then heated at 200°C for 3 min., 300°C for 3 min., and 480°C for 4 min., sequentially, to give a polyimide film having a thickness of 25 µm and showing a linear expansion coefficient of 1.2 x 10⁻⁵ cm/cm/°C at a temperature range of 50 to 250°C.

The polyimide film was then treated in the same manner as in Examples 1 to 2 to give a composite sheet.

### Comparison Example 1

The procedure for preparing a polyimide film which is described in Examples 1 to 2 was repeated except for omitting the coating of aluminum compound, and the resulting polyimide film of 50 µm thick was treated in the same manner as in Examples 1 to 2 to give a composite sheet.

### Evaluation of Composite Sheet

(1) The resulting composite sheet was analyzed for the aluminum content by ICP emission under the following conditions:
   A specimen (approximately 1 g) was fired to give an ash, and the ash was dissolved in an acid. The solution was analyzed by an emission analyzer (UOP-1 MARK-2, available from Kyoto Koken Co., Ltd.)
(2) All of the polyimide films prepared in Examples and Comparison Example had a tensile strength, an extension, a flexing resistance, and an electric insulation at almost the same level as the known polyimide film prepared from a combination of s-BPDA and PPD.

**Table 1**

| Composite sheet | Film thickness (µm) | Al(OH)₃ (added) (ppm) | Al comp. (coated) (wt.%) | Al content (ppm) | Peel resistance (kg/cm) |
|---|---|---|---|---|---|
| Ex. 1 | 50 | --- | 2 | 600 | 2.5 |
| Ex. 2 | 50 | --- | 1.75 | 510 | 2.0 |
| Ex. 3 | 50 | 10 | --- | 4 | 1.6 |
| Ex. 4 | 50 | --- | 2 | 500 | 2.0 |
| Ex. 5 | 50 | --- | 3 | 730 | 2.0 |
| Ex. 6 | 50 | 10 | 0.2 | 65 | 2.0 |
| Ex. 7 | 25 | --- | 3.0 | 700 | 2.2 |
| Com. 1 | 50 | --- | --- | 0.1 | 0 |
| Remarks: 1) The aluminum contents for Examples 1, 2, and 4-7 were measured on the surface on which the aluminum compound was coated. For Example 3, the aluminum content was measured on the surface which had been in contact with the glass plate. 2) For Examples 4 and 5, the coating of the aluminum compound solution was made by dipping the polyimide film into the aluminum compound solution. 3) The polyimide film and the coated metal layers of the composite sheet of Comparison Example 1 spontaneously separated from each other, when the composite sheet was dipped in 2N hydrochloric acid. | | | | | |

### Example 8

To the polyamide acid solution prepared in the same manner as in Example 1, 1,2-dimethylimidazole was added in an amount of 3 wt.% (based on the amount of polyamide solid). The resulting polyamide acid solution was processed in the same manner as in Example 1 to give a dried polyamide acid film. The polyamide acid film was fixed and coated with a xylene solution containing 0.5% aluminum oxide stearate trimer (Algomer-100S, available from Kawaken Fine Chemical Co., Ltd.). The film was then heated in the same manner as in Example 1, to give a polyimide film having a thickness of 50 µm. Thus prepared polyimide film had a modulus of elasticity of 730 kg/mm² (measured according to ASTM D-882), a tensile strength of 35 kg/mm, and an elongation of 40%.

The polyimide film was cleaned on its surface having been coated with an aluminum compound, and on the cleaned surface was formed a copper layer by electron beam deposition. On the deposited copper layer was plated a copper film of 10 µm thick by electrolytic plating, to give a composite sheet.

The resulting composite sheet was analyzed and evaluated in the aforementioned manner. The results are set forth in Table 2.

### Example 9

The procedures of Example 8 were repeated except for replacing the xylene solution containing 0.5% aluminum oxide stearate trimer with a xylene solution containing 0.05% aluminum oxide stearate trimer, to give a polyimide film having almost the same physical characteristics as those of the polyimide film of Example 8. The polyimide film was further processed in the same manner as in Example 8 to give a composite sheet.

The composite sheet was analyzed and evaluated in the same manner. The results are set forth in Table 2.

### Example 10

The procedures of Example 8 was repeated except for replacing the xylene solution containing 0.5% aluminum oxide stearate trimer with a 2-propanol solution containing 0.5% aluminum oxide octylate trimer (Algomer-800A, available from Kawaken Fine Chemical Co., Ltd.), to give a polyimide film having almost the same physical characteristics as those of the polyimide film of Example 8. The polyimide film was further processed in the same manner as in Example 8 to give a composite sheet.

The composite sheet was analyzed and evaluated in the same manner. The results are set forth in Table 2.

### Example 11

The procedures of Example 8 was repeated except for replacing the xylene solution containing 0.5% aluminum oxide stearate trimer with a dimethyl acetone solution containing 3% aluminum ethylacetoacetate diisopropylate (ALCH, available from Kawaken Fine Chemical Co., Ltd.), to give a polyimide film having almost the same physical characteristics as those of the polyimide film of Example 8.

The polyimide film was cleaned on its surface having been coated with an aluminum compound, and on the cleaned surface was formed a copper layer by sputtering. On the copper layer was plated a copper film of 10 µm thick by electrolytic plating, to give a composite sheet.

The composite sheet was analyzed and evaluated in the same manner. The results are set forth in Table 2.

### Example 12

The procedures of Example 8 was repeated except for adding no 1,2-dimethylimidazole and replacing the xylene solution containing 0.5% aluminum oxide stearate trimer with a dimethyl acetone solution containing 3% aluminum ethylacetoacetate diisopropylate, to give a polyimide film having almost the same physical characteristics as those of the polyimide film of Example 8. The polyimide film was further processed in the same manner as in Example 11 to give a composite sheet.

The composite sheet was analyzed and evaluated in the same manner. The results are set forth in Table 2.

**Table 2**

| Composite sheet | Formation of Cu subbing layer | Al content (ppm) | Peel resistance (kg/cm) |
|---|---|---|---|
| Ex. 8 | electron beam deposition | 130 | 1.2 |
| Ex. 9 | electron beam deposition | 15 | 1.3 |
| Ex. 10 | electron beam deposition | 140 | 1.0 |
| Ex. 11 | sputtering | 750 | 2.0* |
| Ex. 12 | sputtering | 750 | 2.0* |

| | | | |
|---|---|---|---|
| Remark: * : peel strength after 15 hours of steam treatment (121°C, PCT) and subsequent immersion in aqueous hydrochloric acid solution. | | | |

It was noted that the surface condition (uniformness) on the electrolytically plated copper film was the best in the Example 11.

Examples 8 to 12 were repeated by a continuous roll process to give satisfactory results.

## Claims

1. An aromatic polyimide film comprising an aromatic polyimide resin and an aluminum-containing material dispersed in the polyimide resin in an amount as aluminum element of 1 to 1,000 ppm, based on the amount of the polyimide film.

2. The aromatic polyimide film of claim 1, wherein the polyimide resin is composed of an aromatic tetracarboxylic acid residue and an aromatic diamine residue.

3. The aromatic polyimide film of claim 1, which is prepared by heating to a temperature of higher than 420°C an aromatic polyamide acid film having thereon an aluminum-containing compound coat or having therein an aluminum-containing compound.

4. The aromatic polyimide film of claim 3, wherein the aluminum-containing compound is aluminum hydroxide or an organic aluminum compound.

5. The aromatic polyimide film of claim 3, wherein the aluminum-containing compound is an organic aluminum compound selected from the group consisting of aluminum monoethylacetate diisopropylate, aluminum diethylacetate monoisopropylate, aluminum triacetylacetonate, aluminum triethyl acetonate, aluminum isopropylate, and aluminum butyrate.

6. An aromatic polyimide composite sheet comprising an aromatic polyimide film and a metal or metal oxide layer arranged on one or both surfaces of the film in which the polyimide film comprises an aromatic polyimide resin and an aluminum-containing material dispersed in the polyimide resin in an amount as aluminum element of 1 to 1,000 ppm based on the amount of the polyimide film, and the metal or metal oxide layer is formed on the film via no adhesive.

7. The aromatic polyimide composite sheet of claim 6, wherein the polyimide resin is composed of an aromatic tetracarboxylic acid residue and an aromatic diamine residue.

8. The aromatic polyimide composite sheet of claim 6, wherein the metal or metal oxide layer is formed on the polyimide film by vapor deposition, ion beam deposition, or sputtering.

9. The aromatic polyimide composite sheet of claim 6, wherein the metal or metal oxide layer has a thickness in the range of 0.01 to 1.0 µm.

10. The aromatic polyimide composite sheet of claim 6, which is prepared by heating to a temperature of higher than 420°C an aromatic polyamide acid film having thereon an aluminum-containing compound coat or having therein an aluminum-containing compound.

11. The aromatic polyimide composite sheet of claim 10, wherein the aluminum-containing compound is aluminum hydroxide or an organic aluminum compound.

12. The aromatic polyimide composite sheet of claim 10, wherein the aluminum-containing compound is an organic aluminum compound selected from the group consisting of aluminum monoethylacetate diisopropylate, aluminum diethylacetate monoisopropylate, aluminum triacetylacetonate, aluminum triethyl acetonate, aluminum isopropylate, and aluminum butyrate.

13. The aromatic polyimide composite sheet of claim 6, wherein the metal or metal oxide layer has a metal film electrolytically or non-electrolytically deposited thereon.

## Patentansprüche

1. Film aus einem aromatischen Polyimid, umfassend ein aromatisches Polyimidharz und ein Aluminiumenthaltendes Material, dispergiert in dem Polyimidharz in einer Menge als elementares Aluminium von 1 bis 1000 ppm, bezogen auf die Menge des Polyimidfilms.

2. Film aus einem aromatischen Polyimid nach Anspruch 1, wobei das Polyimidharz aus einem Rest einer aromatischen Tetracarbonsäure und einem Rest eines aromatischen Diamins zusammengesetzt ist.

3. Film aus einem aromatischen Polyimid nach Anspruch 1, wobei er dadurch erhalten worden ist, dass ein Film aus einer aromatischen Polyamidsäure, auf dem sich ein Überzug aus einer Aluminium-enthaltenden Verbindung befindet oder der darin eine Aluminium-enthaltende Verbindung enthält, auf eine Temperatur von höher als 420°C erhitzt wird.

4. Film aus einem aromatischen Polyimid nach Anspruch 3, wobei die Aluminium-enthaltende Verbindung Aluminiumhydroxid oder eine organische Aluminiumverbindung ist.

5. Film aus einem aromatischen Polyimid nach Anspruch 3, wobei die Aluminium-enthaltende Verbindung eine organische Aluminiumverbindung, ausgewählt aus der Gruppe bestehend aus Aluminiummonoethylacetatdiisopropylat, Aluminiumdiethylacetatmonoisopropylat, Aluminiumtriacetylacetonat, Aluminiumtriethylacetonat, Aluminiumisopropylat und Aluminiumbutyrat, ist.

6. Verbundfolie aus einem aromatischen Polyimid, umfassend einen Film aus einem aromatischen Polyimid und eine auf einer oder beiden Oberflächen des Films angeordnete Metall- oder Metalloxidschicht, wobei der Polyimidfilm ein aromatisches Polyimidharz und ein Aluminiumenthaltendes Material, dispergiert in dem Polyimidharz in einer Menge als elementares Aluminium von 1 bis 1000 ppm, bezogen auf die Menge des Polyimidfilms, enthält, wobei die Metall- oder Metalloxidschicht auf dem Film nicht auf dem Wege über einen Klebstoff gebildet worden ist.

7. Verbundfolie aus einem aromatischen Polyimid nach Anspruch 6, wobei das Polyimidharz aus einem Rest einer aromatischen Tetracarbonsäure und einem Rest eines aromatischen Diamins zusammengesetzt ist.

8. Verbundfolie aus einem aromatischen Polyimid nach Anspruch 6, wobei die Metall- oder Metalloxidschicht auf dem Polyimidfilm durch Dampfabscheidung, Ionenstrahlabscheidung oder Sputtern gebildet worden ist.

9. Verbundfolie aus einem aromatischen Polyimid nach Anspruch 6, wobei die Metall- oder Metalloxidschicht eine Dicke im Bereich von 0,01 bis 1,0 µm hat.

10. Verbundfolie aus einem aromatischen Polyimid nach Anspruch 6, die hergestellt wird, indem ein Film aus einer aromatischen Polyamidsäure, auf dem sich ein Überzug aus einer Aluminium-enthaltenden Verbindung befindet oder der darin eine Aluminium-enthaltende Verbindung enthält, auf eine Temperatur von höher als 420°C erhitzt wird.

11. Verbundfolie aus einem aromatischen Polyimid nach Anspruch 10, wobei die Aluminium-enthaltende Verbindung Aluminiumhydroxid oder eine organische Aluminiumverbindung ist.

12. Verbundfolie aus einem aromatischen Polyimid nach Anspruch 10, wobei die Aluminium-enthaltende Verbindung eine organische Aluminiumverbindung, ausgewählt aus der Gruppe bestehend aus Aluminiummonoethylacetatdiisopropylat, Aluminiumdiethylacetatmonoisopropylat, Aluminiumtriacetylacetonat, Aluminiumtriethylacetonat, Aluminiumisopropylat und Aluminiumbutyrat, ist.

13. Verbundfolie aus einem aromatischen Polyimid nach Anspruch 6, wobei die Metall- oder Metalloxidschicht darauf einen elektrolytisch oder nicht-elektrolytisch abgeschiedenen Metallfilm aufweist.

## Revendications

1. Film de polyimide aromatique comprenant une résine de polyimide aromatique et un matériau à base d'aluminium dispersé dans la résine de polyimide en une quantité, en terme d'élément à base d'aluminium, comprise dans la plage allant de 1 à 1000 ppm, sur la base de la quantité de film de polyimide.

2. Film de polyimide aromatique selon la revendication 1, dans lequel la résine de polyimide est composée d'un résidu d'acide tétracarboxylique aromatique et d'un résidu de diamine aromatique.

3. Film de polyimide aromatique selon la revendication 1, qui est préparé en chauffant à une température supérieure à 420 °C un film d'acide de polyamide aromatique sur lequel est enduit un composé à base d'aluminium ou dans lequel est contenu un composé à base d'aluminium.

4. Film de polyimide aromatique selon la revendication 3, dans lequel le composé à base d'aluminium est un hydroxyde d'aluminium ou un composé organique d'aluminium.

5. Film de polyimide aromatique selon la revendication 3, dans lequel le composé à base d'aluminium est un composé organique d'aluminium choisi dans le groupe comprenant le diisopropylate monoéthylacétate d'aluminium, le monoisopropylate diéthylacétate d'aluminium, le triacétylacétonate d'aluminium, le triéthylacétonate d'aluminium, l'isopropylate d'aluminium et le butyrate d'aluminium.

6. Feuille composite de polyimide aromatique comprenant un film de polyimide aromatique et une couche de métal ou d'oxyde de métal placée sur une ou les deux surfaces du film, dans laquelle le film de polyimide comprend une résine de polyimide aromatique et un matériau à base d'aluminium dispersé dans la résine de polyimide en une quantité, en termes d'élément à base d'aluminium, comprise dans la plage allant de 1 à 1000 ppm, sur la base de la quantité de film de polyimide, et la couche de métal ou d'oxyde de métal est formée sur le film sans adhésif.

7. Feuille composite de polyimide aromatique selon la revendication 6, dans laquelle la résine de polyimide est composée d'un résidu d'acide tétracarboxylique aromatique et d'un résidu de diamine aromatique.

8. Feuille composite de polyimide aromatique selon la revendication 6, dans laquelle la couche de métal ou d'oxyde de métal est formée sur le film de polyimide par métallisation sous vide, dépôt par faisceau ionique ou par pulvérisation.

9. Feuille composite de polyimide aromatique selon la revendication 6, dans laquelle la couche de métal ou d'oxyde de métal a une épaisseur comprise dans la plage allant de 0,01 à 1,0 µm.

10. Feuille composite de polyimide aromatique selon la revendication 6, qui est préparée en chauffant à une température supérieure à 420 °C un film d'acide de polyamide aromatique sur lequel est enduit un composé à base d'aluminium ou dans lequel est contenu un composé à base d'aluminium.

11. Feuille composite de polyimide aromatique selon la revendication 10, dans laquelle le composé à base d'aluminium est un hydroxyde d'aluminium ou un composé organique d'aluminium.

12. Feuille composite de polyimide aromatique selon la revendication 10, dans laquelle le composé à base d'aluminium est un composé organique d'aluminium choisi dans le groupe comprenant le diisopropylate monoéthylacétate d'aluminium, le monoisopropylate diéthylacétate d'aluminium, le triacétylacétonate d'aluminium, le triéthylacétonate d'aluminium, l'isopropylate d'aluminium et le butyrate d'aluminium.

13. Feuille composite de polyimide aromatique selon la revendication 6, dans laquelle un film métallique est déposé électrolytiquement ou non électrolytiquement sur la couche de métal ou d'oxyde de métal.
